# EUROPÄISCHE PATENTSCHRIFT

(11) **EP 1 202 152 B1**
(45) Veröffentlichungstag und Bekanntmachung des Hinweises auf die Patenterteilung: **31.07.2002**
(21) Anmeldenummer: 00122712.3
(22) Anmeldetag: 18.10.2000
(51) Int. Cl.: G06F 1/16, H05K 7/20, F16M 11/00

(54) **Rechnergestütztes Pultsystem**
Computerised desk system
Système de pupitre informatisé

(43) Veröffentlichungstag der Anmeldung: 02.05.2002
(73) Patentinhaber: IN Blechverarbeitungszentrum Sömmerda GmbH, 99610 Sömmerda (DE); General Point of Sale GmbH, 44628 Herne (DE)
(72) Erfinder: Wellhöfer, Stefan, 99195 Schlossvippach (DE)
(74) Vertreter: Kroher, Jürgen

(56) Entgegenhaltungen:
- DE-A- 4 428 937
- US-A- 3 961 666
- PATENT ABSTRACTS OF JAPAN vol. 013, no. 422 (P-933), 20. September 1989 (1989-09-20) & JP 01 154036 A (FUJITSU LTD), 16. Juni 1989 (1989-06-16)

## Beschreibung

Die Erfindung betrifft ein rechnergestütztes Pultsystem der Kommunikationstechnik, durch das, insbesondere in Verbindung mit einer Kundenkarte, Dienstleistungen und Informationen in jedem beliebigen Bereich des Handels und des Dienstleistungsverkehrs dem Kunden zugänglich gemacht werden können.

Derartige Systeme, in der Fachsprache auch Kiosksysteme genannt, sind bereits seit einiger Zeit im Einsatz. Es handelt sich hierbei um Systeme, in denen ein Computer sowie ein Monitor integriert sind, die in ein größeres Gehäuse aus Blechoder Holzbaugruppen verpackt werden. Eine Kommunikation des Kunden ist in den bisherigen Modellen über eine eingebaute Tastatur, via Mouse oder über Touchscreen möglich. Somit erhält der Kunde die Möglichkeit, sich über das jeweilige Angebot an Waren bzw. Dienstleistungen zu informieren sowie über eine persönliche Kundenkarte, die über einen Kartenleser decodiert wird, Käufe zu tätigen. Derartige Kiosksysteme können in allen erdenklichen Bereichen des Waren- bzw. Dienstleistungsverkehrs eingesetzt werden, man denke nur an Tankstellen, Kaufhäuser, Flughäfen, Bahnhöfe usw.

Die Kühlung der wärmeerzeugenden aktiven Bauelemente wie CPU, Netzteil usw. erfolgt bisher üblicherweise durch aktive Lüfter. Da Kiosksysteme in der Regel unbeaufsichtigt und zudem rund um die Uhr eingesetzt werden, ist die Verwendung eines Lüfters, dessen Ausfall zur Zerstörung der wärmeerzeugenden Einheiten, damit zum Ausfall des Systems und zu erhöhten Reparaturkosten führen würde, nicht sachgemäß. Außerdem sind Kiosksysteme oft extremen Umwelteinflüssen ausgesetzt, so daß es erforderlich ist; die aktiven Komponenten möglichst staubund feuchtigkeitsdicht mit einem Gehäuse zu umgeben. In einem solchen Fall bereitet der Einsatz von Lüftern erhöhte Schwierigkeiten.

Aus der US 3 961 666 ist eine Kühlvorrichtung für kleindimensionierte elektronische Bauteile bekannt, die auf einer Kombination zwischen Wärmeleitung und Abgabe der Wärme an die Umgebungsluft beruht. Dabei können auch mehrere wärmeerzeugende elektronische Einheiten auf einer wärmeleitenden Platte montiert werden, die mit Wänden in Berührung steht und die erzeugte Wärme durch Wärmeleitung an diese sowie an Kühlrippen abgibt, die in einem Abstand von 5 mm bis 10 mm an den Wänden vorgesehen sind. Auf die Kühlrippen ist von der anderen Seite eine Platte aufgebracht, so daß zwischen den Kühlrippen nach oben und unten offene Luftröhren entstehen. Die in den Luftröhren befindliche Luft wird beim Betrieb erwärmt und nach oben abgeführt, während von unten durch Öffnungen kühlere Luft nachströmt. Diese Kühlkonstruktion wird innerhalb des Gehäuses von elektrischen Geräten wie Transistoren eingesetzt, wobei nicht vorgesehen ist, das Gehäuse als luftdichten Raum zum Schutz der elektronischen Einheiten gegenüber äußeren Einflüssen auszugestalten.

Der vorliegenden Erfindung liegt die Aufgabe zugrunde, ein rechnergestütztes Pultsystem der Kommunikationstechnik zu schaffen, bei dem die inneren elektrischen und/oder elektronischen Baugruppen gegen Umwelteinflüsse wie Staub, Feuchtigkeit, Korrosion, Wärme, Kälte und Vandalismus geschützt sind, die erzeugte Wärme dennoch sicher abgeführt wird und gleichzeitig der Wartungs- und Reparaturaufwand auf ein Minimum reduziert ist.

Diese Aufgabe wird durch die Merkmale des Anspruchs 1 gelöst.

Das erfindungsgemäße rechnergestützte Pultsystem weist ein Gehäuse auf, das bevorzugt zwei geschlossene, senkrecht oder zumindest schräg zum Erdboden angeordnete Gehäuseabschnitte aus wärmeleitfähigem Material aufweist, die zur Aufnahme von wärmeerzeugenden elektrischen und/oder elektronischen Geräten geeignet sind. Zur Ableitung der von den elektrischen Geräten erzeugten Wärme zu mindestens einer Wandfläche der Gehäuseabschnitte sind Wärmebrücken vorgesehen. Die erwärmten Wandflächen sind von einem Blendenprofil derart umgeben, daß zwischen Gehäuse und Blendenprofil mindestens ein kaminähnlicher Hohlraum entsteht, der in seinem unteren Endbereich mindestens eine Öffnung zur Zuführung kühler Luft in den Hohlraum aufweist sowie mindestens eine Austrittsöffnung im oberen Endbereich des Hohlraums zur Abgabe erwärmter Luft nach außen.

Vorteilhafterweise führt mindestens eine Austrittsöffnung nach außen, so daß die erwärmte Luft in die Umgebung abgegeben werden kann.

Um eine lüfterlose Wärmeableitung von den wärmeerzeugenden Geräten zu gewährleisten, sind diese vorteilhafterweise über wärmeleitende Geräteträger in den Gehäuseabschnitten befestigt.

Für eine Ableitung besonders großer Wärmemengen ist es von Vorteil, daß zwischen den wärmeerzeugenden Geräten und den Wandflächen der Gehäuseabschnitte mindestens ein weiteres Wärmeleitelement, beispielsweise ein Wärmerohr bzw. heat pipe, angeordnet ist.

Dadurch, daß die Wandflächen, zu denen die Wärmeleitung stattfindet, an ihrer Außenseite zusätzlich oberflächenvergrößert sind, wird vorteilhafterweise eine größere Wärmemenge an die Luft in den kaminähnlichen Hohlräumen abgegeben.

Vorteilhafterweise wird die Wärme auf zwei gegenüberliegende, im wesentlichen senkrecht zu einer Frontplatte verlaufende Seitenstege geleitet, so daß nur ein geringer Prozentsatz der Außenflächen aus Sicherheitsgründen überdeckt werden muß.

Vorteilhafterweise sind die Gehäuseabschnitte aus stranggepreßten Aluminiumprofilen gebildet, die leicht bearbeitbar sind, insbesondere durch Laserschweißen verbunden werden können.

Jeder Gehäuseabschnitt weist vorteilhafterweise zwei im wesentlichen senkrecht zur Frontplatte und zu den Seitenstegen verlaufende Querstege auf, wobei Querstege, Seitenstege und Frontplatte jeweils miteinander durch Laserschweißen verbunden sind. Desweiteren ist eine im wesentlichen parallel zur Frontplatte befestigbare Rückwand vorgesehen, die mit den Seitenstegen und den Querstegen abdichtend verbindbar ist, wodurch ein staub- und feuchtigkeitsdichter Behälter für die wärmeerzeugenden Einheiten gebildet wird.

Weitere Einzelheiten, Merkmale und Vorteile der vorliegenden Erfindung ergeben sich aus der nachfolgenden Beschreibung unter Bezugnahme auf die Zeichnungen. Darin zeigt:
- Fig. 1: eine perspektivische Ansicht einer bevorzugten Ausführungsform des erfindungsgemäßen rechnergestützen Pultsystems von vorne,
- Fig. 2: eine perspektivische Ansicht des Pultsystems aus Fig. 1 ohne elektrische Einheiten, Blendenprofil und Rückwand von hinten,
- Fig. 3: eine perspektivische Ansicht einer bevorzugten Ausführungsform des Blendenprofils mit befestigter Rückwand von vorne,
- Fig. 4: eine Vorderansicht des Blendenprofils aus Fig. 3; und
- Fig. 5: einen Querschnitt durch das Blendenprofil in Richtung X - X aus Fig. 4, mit angereihter skizzierter Frontplatte und Seitensteg des Gehäuses.

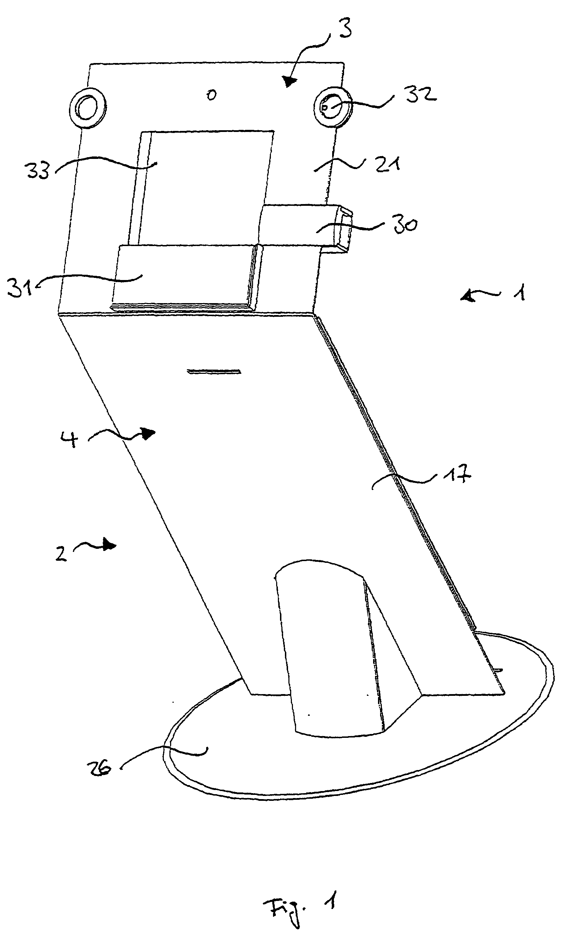

In Fig. 1 ist eine bevorzugte Ausführungsform des erfindungsgemäßen rechnergestützten Pultsystems 1 bzw. Terminals für die Kommunikation in perspektivischer Frontansicht dargestellt. Das Gehäuse 2 besteht hierbei aus einem oberen Gehäuseabschnitt 3 und einem unteren Gehäuseabschnitt 4, der auf einer Fußplatte 26 befestigt ist. Die beiden Gehäuseabschnitte 3 und 4 sind winkelig miteinander verbunden, vorzugsweise verschraubt, wobei der untere Gehäuseabschnitt 4 schräg montiert ist, derart, daß er sich einem Benutzer entgegenneigt und diesem an seinem unteren Ende ausreichend Beinfreiheit gewährt. Der obere Gehäuseabschnitt 3 ist von der Verbindungsnahtstelle mit dem unteren Gehäuseabschnitt 4 aus schräg nach hinten und oben geneigt, um dem Benutzer die Bedienung des Pultes zu erleichtern. Dabei ist wichtig, daß der obere Gehäuseabschnitt 3 nicht parallel zum Erdboden, sondern deutlich schräg dazu angeordnet ist.

Die beiden Gehäuseabschnitte 3 und 4 bestehen hierbei aus stranggepreßten Aluminiumprofilen, und deren einzelne Teile sind vorzugsweise durch Laserschweißen, ansonsten über Verschraubung, miteinander verbunden.

Außer der Ausgestaltung als Pultsystem ist es auch möglich, die beiden Gehäuseabschnitte 3 und 4 voneinander getrennt senkrecht an einer Wand anzuordnen oder als Einbausystem zu verwenden. Auch ist es denkbar, den unteren Gehäuseabschnitt 4 vertikal an einer Wand zu montieren und den oberen Gehäuseabschnitt 3 schräg davon nach unten wegstehen zu lassen, wobei er an seiner Oberkante an dem unteren Gehäuseabschnitt 4 angesetzt ist.

Der untere Gehäuseabschnitt 4 wird frontseitig durch eine einstückig ausgebildete Frontplatte 17, der obere Gehäuseabschnitt 3 durch eine Frontplatte 21 begrenzt.

Der untere Gehäuseabschnitt 4 dient zur Aufnahme wärmeerzeugender Geräte, wie beispielsweise Computer, Drucker, Netzgerät usw., während im oberen Gehäuseabschnitt 3 alle Bedien- und Anzeigeelemente untergebracht sind. Im einzelnen sind dies Sichtfläche oder Touchscreen 33, Kartenleser 30, Tastatur 31 und Spracheingabeeinheit 32. Die Bedienung des Terminals kann somit bevorzugterweise sowohl über die Tastatur, über den Touchscreen als auch über Spracheingabe erfolgen.

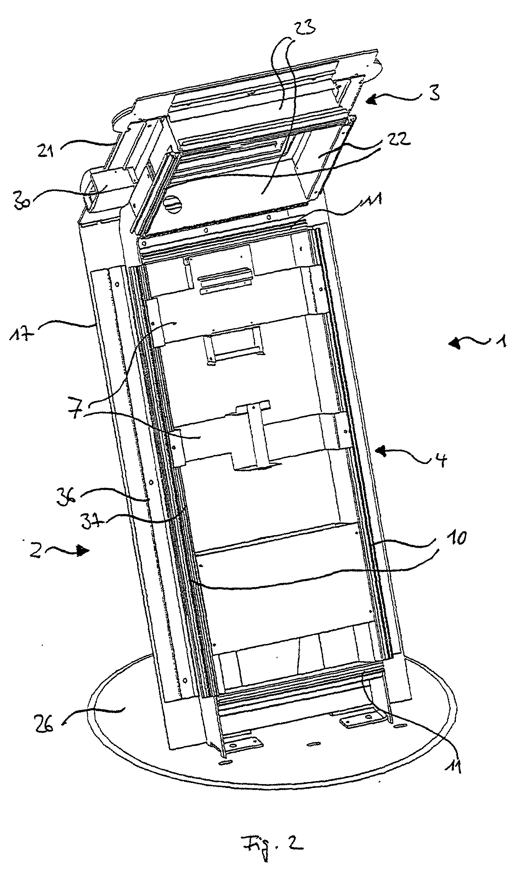

In Fig. 2 ist dieselbe Anordnung in Rückansicht gezeigt. Hieraus ist ersichtlich, daß der untere Gehäuseabschnitt 4 jeweils zwei parallel zueinander angeordnete und senkrecht zur Frontplatte 17 verlaufende Seitenstege 10 und Querstege 11 aufweist. Die Seitenstege 10 und die Querstege 11 sind rechteckförmig zueinander angeordnet, so daß ein durch die Frontplatte 17 begrenzter Innenraum zur Aufnahme von Computer, Drucker etc. (nicht gezeigt) gebildet wird, der durch die Rückwand (nicht gezeigt) feuchtigkeits- und staubdicht geschlossen werden kann, wie später noch beschrieben wird. Ähnliches gilt für den oberen Gehäuseabschnitt 3 mit Seitenstegen 22 und Querstegen 23.

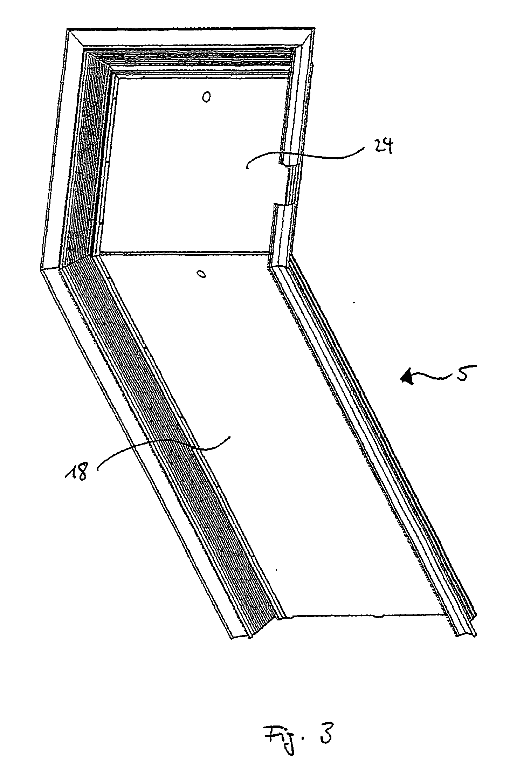

Die Frontplatten 17, 21 erstrecken sich in seitlicher Richtung über die Seitenstege 10, 23 hinaus aus. An diesen äußeren Rändern ist parallel zu den Seitenstegen 10, 22 jeweils eine Leiste 36 ausgebildet. Auf dem rückwärtigen Ende der Seitenstege 10, 22 ist ebenfalls eine Leiste 37 ausgebildet. Diese Leisten 36, 37 dienen zum Eingriff in Nuten des in den Fig. 3 bis 5 beschriebenen Blendenprofils.

Im Innenraum der Gehäuseabschnitte 3, 4 sind Geräteträger 7 angeordnet, die an den Seitenstegen 10, 22 durch Klemmen oder Schrauben befestigt sind. Diese Geräteträger 7 dienen zur Befestigung von Computer, Drucker usw. und bestehen aus sehr wärmeleitfähigem Material, bevorzugterweise aus Aluminium.

In Fig. 3 ist das gesamte Blendenprofil 5 für oberen und unteren Gehäuseabschnitt dargestellt. Hierbei ist zu beachten, daß nach der Montage an das Gehäuse die Rückwände 18, 24 dichtend mit den jeweiligen Seitenstegen und Querstegen abschließen sollen. Dazu werden für einen Fachmann übliche Dichtungsmechanismen verwendet.

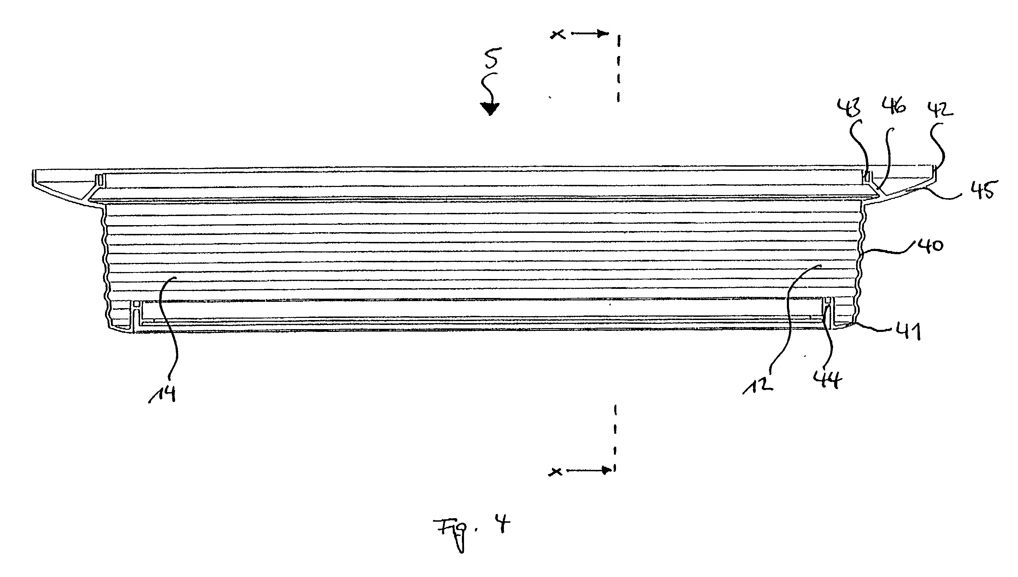

In Fig. 4 ist eine bevorzugte Ausführungsform des Blendenprofils schematisch dargestellt. Dabei stellt der linke Rand den oberen Endbereich 14 und der rechte Rand den unteren Endbereich 12 eines Blendenprofils 5 bzw. des später beschriebenen Hohlraums dar, wenn das Profil 5 von hinten betrachtet links eingesetzt wird. Die Geometrie des Blendenprofils auf der rechten Seite ist dazu symmetrisch. Das Blendenprofil 5 besteht aus einem im wesentlichen senkrecht zu den Seitenstegen 10, 22 angeordneten Hauptabschnitt 40, der an seinem einen Ende einen U-förmigen Fortsatz 41 aufweist, an dessen freiem Schenkel eine Nut 44 zur Aufnahme von Leiste 37 angeordnet ist. An seinem anderen Ende weist der Hauptabschnitt 40 eine im wesentlichen senkrecht dazu abgewinkelte Zunge 45 auf, an deren äußerem Ende ein Fortsatz 42 angeordnet ist, der im wesentlichen parallel zum Hauptabschnitt 40 verläuft. In Richtung des anderen Endes der Zunge befindet sich ein auskragender Steg 46, an dessen äußerem Ende eine weitere Nut 43 zur Aufnahme von Leiste 36 angeordnet ist.

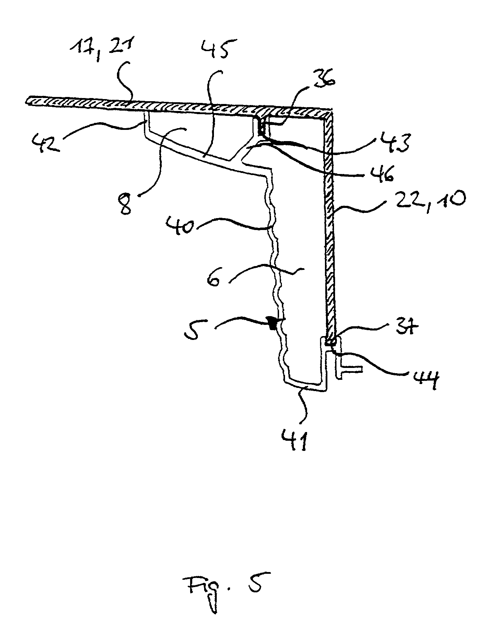

Wie aus Fig. 5 ersichtlich, wird zwischen den Seitenstegen 10, 22 und dem Hauptabschnitt 40 des Blendenprofils 5 über die beiden Verbindungen der Leisten 36, 37 mit den Nuten 43, 44 ein erster Hohlraum 6 erzeugt, der sich über nahezu die gesamte Höhe des Gehäuses erstreckt. Des weiteren wird zwischen Zunge 45 und äußerem Rand der rückwärtigen Seite der Frontplatte 17, 21 ein weiterer, kleinerer Hohlraum 8 mit den seitlichen Abschlüssen durch auskragenden Steg 46 und Fortsatz 42 gebildet.

Vor Inbetriebnahme des Pultsystems werden in das Gehäuse 2 zunächst die gewünschten elektrischen und/oder elektronischen Einheiten eingesetzt und an den Geräteträgem 7 befestigt. Anschließend werden das Blendenprofil 5 und die Rückplatten 18, 24 derart auf das Gehäuse 2 aufgesetzt, daß die Nuten 43 und 44 des Blendenprofils 5 in Eingriff mit den Leisten 36 und 37 kommen und die Rückwände 18, 24 dichtend mit den entsprechenden Seitenstegen und Querstegen abschlieβen. Blendenprofil 5 und Rückwände 18, 24 werden anschließend mit dem Gehäuse 2 verschraubt. Somit sind die Geräteeinheiten vor Umwelteinflüssen sicher untergebracht.

Die im Betrieb des Gerätes erzeugte elektrische Wärme wird nun über die Geräteträger 7 zu den Seitenstegen 10, 22 abgeführt, wodurch diese auf bis zu 90° C erhitzt werden. Bei extrem hohen abzuleitenden Wärmemengen können außerdem zusätzliche Wärmebrücken, beispielsweise Wärmerohre bzw. heat pipes, verwendet werden, um die Wärme zu den Seitenstegen zu leiten. Durch die erhöhte Temperatur der Seitenstege 10, 22 erwärmt sich die Luft im Hohlraum 6 und steigt in diesem nach oben. Zusätzlich strömt über eine Öffnung im unteren Endbereich 12 des Blendenprofils 5 bzw. über die Öffnung, die entsteht, wenn der Hohlraum nach unten nicht verschlossen wird, kühle Luft von unten in den Hohlraum 6 nach. Die nach oben steigende erwärmte Luft wird durch Öffnungen im oberen Endbereich 14 des Blendenprofils 5 nach außen abgeführt. Das gleiche Prinzip gilt für die weniger stark erwärmte Luft in Hohlraum 8.

Es ist klar, daß bei besonders hohen abzutransportierenden Wärmemengen die Anzahl der an den Seitenstegen anliegenden Hohlräume, etwa durch Einsatz eines anders gestalteten Blendenprofils, erhöht werden könnte, sei es durch Aufteilung von Hohlraum 6 in mehrere kleine Hohlräume oder durch Hinzufügen weiterer Hohlräume.

Es ist auch denkbar, daß bei geringen Wärmemengen Luftzirkulation zur Kühlung ausreicht. Der mindestens eine Hohlraum könnte dazu im oberen Endbereich über einen Verbindungskanal mit einem weiteren, kühlen Hohlraum (nicht gezeigt) verbunden sein, so daß die erwärmte Luft in den kühlen Hohlraum eindringt und dort durch Absinken aufgrund von Abkühlung sowie durch Nachdrängen warmer Luft aus Hohlraum 6 und/oder 8 eine Verdrängung der Luft nach unten erfolgt.

Durch diesen Kühlungsmechanismus werden erhebliche Wärmemengen nach außen transportiert, und es wird gewährleistet, daß die gemäß den Vorschriften zur Gerätesicherheit zu beachtende Höchstgrenze der Temperatur an Außenflächen von 42°C weder an der Front- oder Rückplatte noch am Blendenprofil erreicht wird.

## Patentansprüche

1. Rechnergestütztes Pultsystem (1) der Kommunikationstechnik mit einem Gehäuse (2), das mindestens einen, bevorzugt zwei, geschlossene, senkrecht oder schräg zum Erdboden angeordnete Gehäuseabschnitte (3, 4) aus zumindest überwiegend wärmeleitfähigem Material aufweist, die zur Aufnahme von wärmeerzeugenden elektrischen und/oder elektronischen Geräten wie Computer, Drucker, Netzgerät, Bildschirmanzeige etc. geeignet sind, mit Wärmebrücken zur Leitung der von den elektrischen Geräten erzeugten Wärme zu mindestens einer Wandfläche der Gehäuseabschnitte (3, 4), die von einem Blendenprofil (5) derart umgeben ist, daß zwischen Gehäuse (2) und Blendenprofil (5) mindestens ein kaminähnlicher Hohlraum (6) entsteht, der in seinem unteren Endbereich (12) mindestens eine Öffnung zur Zuführung kühler Luft in den Hohlraum (6) aufweist, sowie mindestens eine Austrittsöffnung im oberen Endbereich (14) des Hohlraums (6) zur Abgabe erwärmter Luft nach außen.

2. Rechnergestütztes Pultsystem (1) der Kommunikationstechnik nach einem der vorangehenden Ansprüche, **dadurch gekennzeichnet, daß** das Gehäuse (2) einen oberen Gehäuseabschnitt (3) zur Aufnahme von Anzeige- und Bedienelementen und einen unteren Gehäuseabschnitt (4) zur Aufnahme von Rechner, Drucker, Netzgerät etc. aufweist, die miteinander verbindbar sind.

3. Rechnergestütztes Pultsystem (1) der Kommunikationstechnik nach einem der vorangehenden Ansprüche, **dadurch gekennzeichnet, daß** die elektrischen und/oder elektronischen Geräte in den Gehäuseabschnitten (3, 4) über Geräteträger (7) befestigt sind, die zur Wärmeableitung geeignet sind.

4. Rechnergestütztes Pultsystem (1) der Kommunikationstechnik nach einem der vorangehenden Ansprüche, **dadurch gekennzeichnet, daß** mindestens ein weiteres Wärmeleitelement zum Transport der Wärme von den wärmeerzeugenden Geräten zu Wandflächen der Gehäuseabschnitte (3, 4) angeordnet ist.

5. Rechnergestütztes Pultsystem (1) der Kommunikationstechnik nach Anspruch 6, **dadurch gekennzeichnet, daß** das Wärmeleitelement eine heat pipe ist.

6. Rechnergestütztes Pultsystem (1) der Kommunikationstechnik nach einem der vorangehenden Ansprüche, **dadurch gekennzeichnet, daß** die Wandflächen, zu denen die Wärmeleitung stattfindet, an ihrer Außenseite zusätzlich oberflächenvergrößert sind.

7. Rechnergestütztes Pultsystem (1) der Kommunikationstechnik nach einem der vorangehenden Ansprüche, **dadurch gekennzeichnet, daß** die Wandflächen, zu denen die Wärmeleitung stattfindet, zwei gegenüberliegende, im wesentlichen senkrecht zu einer Frontplatte (17, 21) verlaufende Seitenstege (10, 22) sind.

8. Rechnergestütztes Pultsystem (1) der Kommunikationstechnik nach einem der vorangehenden Ansprüche, **dadurch gekennzeichnet, daß** die Gehäuseabschnitte (3, 4) aus stranggepreßten Aluminiumprofilen gebildet sind.

9. Rechnergestütztes Pultsystem(1) der Kommunikationstechnik nach einem der vorangehenden Ansprüche, **dadurch gekennzeichnet, daß** jeder Gehäuseabschnitt (3, 4) zwei im wesentlichen senkrecht zur Frontplatte (17, 21) und zu den Seitenstegen (10, 22) verlaufende Querstege (11, 23) aufweist, und daß Querstege (11, 23), Seitenstege (10, 22) und Frontplatte (17, 21) miteinander jeweils durch Laserschweißen verbunden sind.

10. Rechnergestütztes Pultsystem (1) der Kommunikationstechnik nach einem der vorangehenden Ansprüche, **dadurch gekennzeichnet, daß** jeder Gehäuseabschnitt (3, 4) eine im wesentlichen parallel zur Frontplatte (17, 21) befestigbare Rückwand (18, 24) aufweist, die mit den Seitenstegen (10, 22) und den Querstegen (11, 23) abdichtend verbindbar ist.

## Claims

1. A computer desk system (1) of the communication technology, comprising a housing (2) having at least one, preferably two closed housing sections (3, 4) arranged perpendicularly or obliquely with respect to the ground, said housing sections being made of an at least predominantly heat conductive material and are adapted for receiving heat generating, electric and/or electronic apparatus such as computers, printers, power packs, screen displays etc, and comprising heat bridges for conducting the heat generated by the electric devices to at least one wall surface of the housing sections (3, 4), which is encompassed by a screen profile (5) in a manner that at least one chimney-like cavity (6) is formed between the housing (2) and the screen profile (5), said cavity having at its lower end portion (12) at least one opening for supplying cool air into the cavity (6), and at least one outlet opening at the upper end portion (14) of the cavity (6) for discharging heated air to the atmosphere.

2. A computerized desk system (1) of the communication technology according to one of the preceding claims, **characterized in that** the housing (2) has an upper housing section (3) for accommodating display and operating elements and a lower housing section (4) for accommodating a computer, printer, power pack etc. which are connectable to one another.

3. A computerized desk system (1) of the communication technology as claimed in one of the preceding claims, **characterized in that** the electric and/or electronic devices are attached in the housing sections (3, 4) via device carriers (7) which are adapted to discharge heat.

4. A computerized desk system (1) of communication technology as claimed in one of the preceding claims, **characterized in that** at least one further heat conducting element for transporting heat from the heat generating devices to wall surfaces of the housing sections (3, 4) is arranged.

5. A computerized desk system (1) of the communication technology as claimed in claim 6, **characterized in that** the heat conducting element is a heat pipe.

6. A computerized desk system (1) of the communication technology as claimed in one of the preceding claims, **characterized in that** the wall surfaces to which the heat conduction takes place has an additionally enlarged surface on its outer side.

7. A computerized desk system (1) of the communication technology as claimed in one of the preceding claims, **characterized in that** the wall surfaces to which the heat conduction takes place are two opposing side webs (10, 22) extending substantially perpendicularly to a front plate (17, 21).

8. A computerized desk system (1) of the communication technology as claimed in one of the preceding claims, **characterized in that** the housing sections (3, 4) are formed of extruded aluminum profiles.

9. A computerized desk system (1) of the communication technology as claimed in one of the preceding claims, **characterized in that** each housing section (3, 4) comprises two transverse webs (11, 23) extending substantially perpendicularly to the front plate (17, 21) and to the side webs (10, 22), and that the transverse webs (11, 23), the side webs (10, 22) and the front plate (17, 21) are connected to each other by laser welding.

10. A computerized desk system (1) of the communication technology as claimed in one of the preceding claims, **characterized in that** each housing section (3, 4) comprises a rear wall (18, 24), which is attachable substantially in parallel to the front plate (17, 21), said rear wall being sealingly connectable to the side webs (10, 22) and the transverse webs (11, 23).

## Revendications

1. Système de pupitre informatique (1) de la technique de communication comportant un coffret (2), qui présente au moins une, de préférence deux sections de coffret (3, 4) fermées, disposées verticalement ou obliquement par rapport au sol, en matériau au moins principalement conducteur de la chaleur, qui sont adaptées pour recevoir des appareils électriques et/ou électroniques producteurs de chaleur, comme ordinateur, imprimante, boîtier secteur, écran etc., avec des ponts thermiques pour conduire la chaleur produite par les appareils électriques vers au moins une surface formant paroi des sections de coffret (3, 4), qui est entourée de manière telle par un profilé écran (5), qu'entre le coffret (2) et le profilé écran (5) il se crée au moins un espace creux (6) similaire à une cheminée, qui présente dans sa zone d'extrémité inférieure (12) au moins une ouverture pour acheminer de l'air froid dans l'espace creux (6), ainsi qu'au moins une ouverture de sortie dans la zone d'extrémité supérieure (14) de l'espace creux (6) pour rejeter l'air réchauffé vers l'extérieur.

2. Système de pupitre informatique (1) de la technique de communication selon l'une des revendications précédentes, **caractérisé en ce que** le coffret (2) présente une section de coffret supérieure (3) pour recevoir des éléments d'affichage et de commande et une section de coffret inférieure (4) pour recevoir un ordinateur, une imprimante, un boîtier secteur etc., qui peuvent être reliés les uns aux autres.

3. Système de pupitre informatique (1) de la technique de communication selon l'une des revendications précédentes, **caractérisé en ce que** les appareils électriques et/ou électroniques sont fixés dans les sections de coffret 53, 4) par l'intermédiaire de supports d'appareils (7), qui sont adaptés pour évacuer la chaleur.

4. Système de pupitre informatique (1) de la technique de communication selon l'une des revendications précédentes, **caractérisé en ce qu'**au moins un autre élément conducteur de la chaleur est disposé pour transporter la chaleur des appareils producteurs de chaleur vers des surfaces formant parois des sections de coffret (3, 4).

5. Système de pupitre informatique (1) de la technique de communication selon la revendication 6, **caractérisé en ce que** l'élément conducteur de la chaleur est une caloduc.

6. Système de pupitre informatique (1) de la technique de communication selon l'une des revendications précédentes, **caractérisé en ce que** les surfaces formant parois, vers lesquelles a lieu la conduction thermique, sont en outre agrandies en surface, sur leur côté extérieur.

7. Système de pupitre informatique (1) de la technique de communication selon l'une des revendications précédentes, **caractérisé en ce que** les surfaces formant parois vers lesquelles a lieu la conduction thermique sont deux montants latéraux (10, 22) s'étendant face à face, sensiblement à la perpendiculaire d'une plaque avant (17, 21).

8. Système de pupitre informatique (1) de la technique de communication selon l'une des revendications précédentes, **caractérisé en ce que** les sections de coffret (3, 4) sont formés de profilés d'aluminium extrudés.

9. Système de pupitre informatique (1) de la technique de communication selon l'une des revendications précédentes, **caractérisé en ce que** chaque section de coffret (3, 4) présente deux montants transversaux (11, 23) s'étendant sensiblement à la perpendiculaire de la plaque avant (17, 21) et des montants latéraux (10, 22) et **en ce que** montants transversaux (11, 23), montants latéraux (10, 22) et plaque avant (17, 21) sont assemblés les uns aux autres, chaque fois par soudage au laser.

10. Système de pupitre informatique (1) de la technique de communication selon l'une des revendications précédentes, **caractérisé en ce que** chaque section de coffret (3, 4) présente une paroi arrière (18, 24) pouvant être fixée sensiblement parallèlement à la plaque avant (17, 21), qui peut être assemblée de manière étanche avec les montants latéraux (10, 22) et les montants transversaux (11, 23).
